# EUROPEAN PATENT APPLICATION

(11) **EP 1 791 406 A1**
(43) Date of publication of application: **30.05.2007**
(21) Application number: 06077047.6
(22) Date of filing: 17.11.2006
(51) Int. Cl.: H05K 3/30

(54) **Method of forming a composite standoff on a ciruit board**

(30) Priority: 28.11.2005 US 287962
(71) Applicant: Delphi Technologies, Inc., Troy, Michigan 48007 (US)
(72) Inventor: Chan, Su Liang, 574329 Singapore (SG); Nah, Chih Kai, 510184 Singapore (SG); Pan, Binghua, 760795 Singapore (SG); Schofield, Robert A., Lymm Cheshire WA13 0BJ (GB); Cheok, Cheng Gek, 319773 Singapore (SG); Chengalva, Mahesh K., Kokomo, IN 46902 (US)
(74) Representative: Denton, Michael John

(57) **Abstract**

A composite standoff is formed on a circuit board during the processing of the circuit board while an array of electrical circuit traces including contact pads are formed, portions of the electrical circuit traces are covered by a solder mask, and legend ink is applied to the circuit board for locating electronic components on the circuit board without any need for an additional step.

## Description

### Field of the Invention

This invention relates to a circuit board having a surface mounted electronic components and more particularly to a method of forming a standoff on the circuit board to space the electronic component from the surface of the circuit board.

### Background of the Invention

An electronic component is typically mounted on a circuit board by attaching terminations on the bottom of the electronic component to contact pads on the circuit board by soldering techniques. See for instance U.S. Patent 6,525,628 B1 issued to Andrew P. Ritter et al February 25, 2003. In such a mounting process one or more standoffs may be formed on the circuit board to space the bottom surface of the electronic component from the surface of the circuit board prior to the soldering operation. See for instance, U.S. Patent No. 5,056,215 entitled "Method of Providing Standoff Pillars", granted to James A. Blanton October 15, 1991 and U.S. Patent No. 6,773,957 B2, entitled "Stereographic Method and Apparatus for Fabricating Spacers for Semiconductor Devices and Resulting Structures", granted to Warren M. Farnworth August 10, 2004.

### Summary of the Invention

This invention provides a method of forming a precise and controllable standoff on a circuit board while processing the circuit board that does not require any additional process steps. Forming precise and controllable standoffs are particularly important in mounting larger electronic components such as the RC arrays disclosed in the Ritter et al '628 patent because the standoff height can increase the solder joint life expectancy significantly.

### Brief Description of the Drawings

Figure 1 is a flow chart for processing a circuit board for surface mounting an electronic component to the circuit board that includes forming a composite standoff according to the method of the invention;
Figure 2 is a fragmentary top view of a circuit board having a composite standoff formed by the method of the invention;
Figure 3 is a section taken substantially along the line 3-3 of figure 2 looking in the direction of the arrows; and
Figure 4 is a sectional view of an electronic component mounted on the circuit board shown in figures 2 and 3.

### Detailed Description of Preferred Embodiment

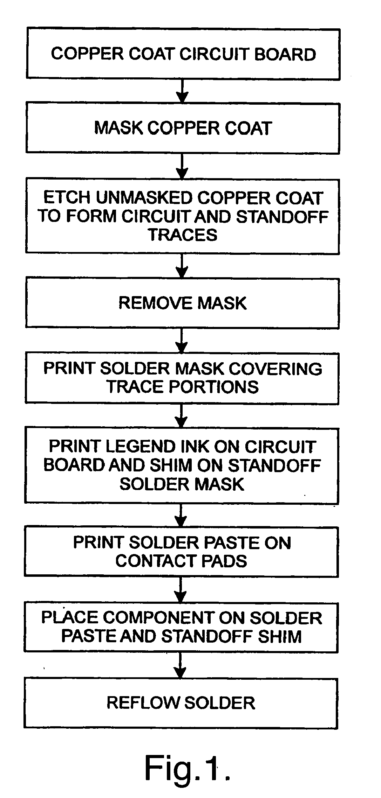

Referring now to figure 1, a flow chart for processing a circuit board and surface mounting an electronic component on the circuit board is illustrated. Briefly, a suitable nonconductive substrate typically of plastic material, is coated with a thin layer of conductive material, usually copper or a copper alloy. The thin conductive layer is then masked with a pattern that corresponds to the shapes and locations of desired electrical circuit traces and in this instance, the pattern also includes one or more bases for desired composite standoffs. The unmasked areas of the conductive layer are then etched to leave the desired electrical circuit traces and standoff bases. The mask is then removed from the electrical circuit traces and standoff bases. At this point it should be noted that the electrical circuit traces commonly include contact pads for making electrical connections to electronic components.

Next a solder mask is applied to portions of the electrical circuit traces and standoff bases, for example by printing or spray coating the portions of the traces except for the contact pads that need solder. At this point it should be noted that the standoff bases are also covered with the solder mask to build up composite standoffs when the solder mask is applied to portions of the electrical circuit traces. The solder mask forms covers on the standoff bases that preferably completely cover the standoff bases.

Any suitable material known in the art may be used for the solder mask. For example, a suitable material for the solder mask is 77MA that is commercially available material from Vantico. This material is a generally photoimageable, modified epoxy.

Legend ink is then printed on the circuit board to identify the various mounting areas for the various electronic components which is a well known processing step. However, at the same time, legend ink is also printed on the covers of the composite standoffs to form shims atop the covers that provide a precise height for the composite standoffs. Any suitable legend ink known in the art may be used. Suitable legend inks are commercially available from Taiyo which is a well known company.

Solder paste is then printed on the unmasked contact pads. The solder paste is preferably applied after the legend ink is applied to the circuit board and the covers of the composite standoffs.

An electronic component is then placed on the solder paste atop the contact pads and on the composite standoffs. The solder is then reflowed and solidified to attach the electronic component to the circuit board.

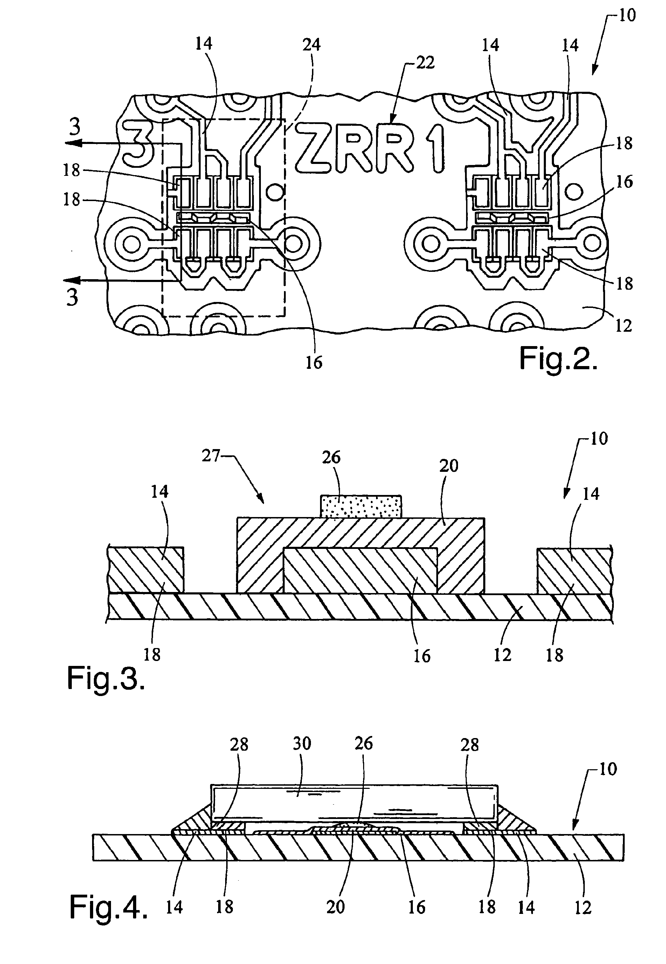

Figure 2 is a fragmentary top view of a circuit board 10 having a composite standoff formed by the method of the invention. Figure 3 is a section taken substantially along the line 3-3 of figure 2 looking in the direction of the arrows. As indicated above, circuit board 10 comprises a suitable nonconductive substrate 12. The circuit board 10 is processed to provide a desired pattern of electrical circuit traces 14 and standoff bases 16 comprising of a thin layer of copper, copper alloy or other suitable conductive material. The electrical circuit traces 14 include contact pads 18 for making electrical connections with electronic components. In this particular example, circuit board 10 has two sets of eight contact pads 18 for making electric electrical connections with two electronic components (not shown).

As shown in figures 2 and 3, the typical standoff base 16 has a cover 20 of solder mask material. Cover 20 preferably completely covers the standoff base 16. As indicated above, the cover 20 is formed when the solder mask is applied to portions of the electrical circuit traces 14 (except for the contact pads 18 that need solder) as well as the standoff base16.

Legend ink is then printed on the circuit board 10 to identify the various mounting areas for various electronic components. For instance, the legend "ZRR1" indicated generally at 22 in figure 2 is printed near the mounting area on the circuit board 10 for an electronic component as shown by the dashed line 24. At the same time, legend ink is also printed on the cover 20 of the standoff to provide a shim 26 that finishes the composite standoff 27 providing a precise and controllable height for the composite standoff 27. It should be noted that legend ink has a relatively high viscosity in comparison to solder and that the legend ink is applied by a printing process that can be localized. Consequently, the form, shape and height of the shim can be controlled in a precise manner by varying the printing process parameters such as number of prints, emulsion thickness, and curing process. Hence a precise and controllable height is achievable.

Solder paste 28 is printed on the contact pads 18 as shown in figure 4. The solder paste is preferably applied to contract pads 18 after the legend ink is applied to the circuit board 10 and the composite standoffs 27. In this manner, the legend ink can be applied by the manufacturer of the printed circuit board while the solder paste can be applied at another manufacturing facility, for instance at the manufacturing facility of the printed circuit board customer.

An electronic component 30 is then placed on the solder paste 28 atop the contact pads 18 and on the composite standoff 27 that is midway between the contact pads 18. The solder paste 28 is then reflowed and solidified to attach an electronic component 30 to circuit board 12 as shown in figure 4.

Thus the method of the invention forms a composite standoff of precise height for locating the electronic component 30 a precise distance above the circuit board 10 without requiring any additional steps during the processing of the circuit board 10. With composite shim 26, the solder standoff height of electronic components can be increased easily to increase the solder joint life expectancy.

While the composite standoff 27 is illustrated as having a wavy shim 26 it should be understood that the shim 26 can take many shapes and forms. For instance shim 26 could be a single strip line, a double line or a plurality of staggered dots. Moreover, while the composite standoff 27 is illustrated as a single linear standoff midway between two rows of contact pads 18, it should be understood, that any number and/or shapes of standoffs can be formed. For instance, the four corner standoffs shown in U.S. Patent 5,056,215 cited above could be formed as composite standoffs by the method of the invention.

In other words, it will be readily understood by those persons skilled in the art that the present invention is susceptible of broad utility and application. Many embodiments and adaptations of the present invention other than those described above, as well as many variations, modifications and equivalent arrangements, will be apparent from or reasonably suggested by the present invention and the foregoing description, without departing from the substance or scope of the present invention. Accordingly, while the present invention has been described herein in detail in relation to its preferred embodiment, it is to be understood that this disclosure is only illustrative and exemplary of the present invention and is made merely for purposes of providing a full and enabling disclosure of the invention. The foregoing disclosure is not intended or to be construed to limit the present invention or otherwise to exclude any such other embodiments, adaptations, variations, modifications and equivalent arrangements, the present invention being limited only by the following claims and the equivalents thereof.

## Claims

1. A method of forming a composite standoff on a circuit board 12 during the processing of the circuit board comprising:
forming a conductive standoff base 16 while forming an electrical circuit trace 14 of the same material on the circuit board,
forming a cover 20 on the conductive standoff base by applying a solder mask to the standoff base while applying a solder mask of the same material to at least a portion of the electrical circuit trace, and
applying legend ink to the cover formed by applying solder mask to the standoff base to complete a composite standoff of precise height while applying legend ink to the circuit board for locating components on the circuit board so that the composite standoff is formed without any need for an additional process step.

2. The method of claim 1 wherein the electrical circuit trace 14 is spaced from the conductive standoff base 16 and includes a contact pad 18 and the solder is not applied to the contact pad.

3. The method of claim 1 or 2 wherein a plurality of conductive standoff bases 16 are formed while forming an array of electrical circuit traces 14 of the same material on the circuit board simultaneously, the array of electrical circuit traces 14 being spaced from the plurality of conductive standoff bases 16 and including sets of contact pads 18;
the covers 20 are formed on the conductive standoff bases by applying the solder mask to the standoff bases while applying the solder mask of the same material to at least portions of the electrical circuit traces but not to the contact pads, and
the legend ink is applied to the covers 20 to complete composite standoffs of precise height while applying the legend ink to the circuit board for locating components on the circuit board so that the composite standoffs are formed without any need for an additional process step.
